# EUROPEAN PATENT APPLICATION

(11) **EP 4 560 919 A1**
(43) Date of publication of application: **28.05.2025**
(21) Application number: 23212006.3
(22) Date of filing: 24.11.2023
(51) Int. Cl.: H03K 3/356

(54) **LEVEL SHIFTER**

(71) Applicant: Imec VZW, 3001 Leuven (BE); Katholieke Universiteit Leuven KU Leuven Research & Development, 3000 Leuven (BE)
(72) Inventor: CHEN, Wen-Chieh, 3001 Heverlee (BE); HUANG, Man-Ching, 83002 Kaohsiung City (TW); CHEN, Shih-Hung, 3010 Kessel-Lo (BE)
(74) Representative: Lind Edlund Kenamets Intellectual Property AB

(57) **Abstract**

In an aspect, there is provided a level shifter (1) for down-shifting a voltage level of a digital input signal (LDS_IN), comprising:
a first branch (10) and a second branch (20), each comprising:
an input (13, 21) configured to receive the digital input signal;
a high-side transistor (130, 230) having a first current terminal coupled to a main supply voltage rail (2VDD), a second current terminal coupled to a first node (10a, 20a) of the respective branch, and a gate coupled to the input;
a low-side transistor (110, 210) having a first current terminal coupled to a reference voltage rail (VSS), a second current terminal coupled to a second node (10b, 20b) of the respective branch, and a gate coupled to the second node (20b, 10b) of the other branch, wherein the second node of the first or second branch is an output (LDS_OUT) of the level shifter; and
a stack of N transistor pairs (121, 221) coupled in series between the first and the second nodes, wherein each transistor pair comprises an nMOSFET, and a pMOSFET, the nMOSFET being subsequent to the pMOSFET as seen from the first node to the second node,
wherein gates of each respective transistor pair of the stack are configured to be biased by a respective bias voltage (VDD) of a level intermediate the main supply voltage and the reference voltage.

## Description

### TECHNICAL FIELD

The present invention generally relates to a level shifter for down-shifting a voltage level of a digital input signal.

### BACKGROUND

Level shifters are important components of many state-of-the-art integrated circuits (ICs), such as system-on-chips (SoCs). To address the often competing aims of high performance and low power consumption, ICs such as SoCs are typically mixed-voltage circuits including a number of different voltage domains (different ranges of the voltages). A level shifter allows an input voltage to be shifted from a first voltage domain of a first circuit block to a second voltage domain of a second circuit block.

A level-down shifter is a level shifter specifically configured to down-shift a voltage level of an input signal from a higher voltage domain to a lower voltage domain. In an I/O buffer application, a level-down shifter may for instance be used to down-shift a digital input voltage with a voltage swing of 1VDD/2VDD, 2VDD/3VDD or 3VDD/4VDD to VSS/1VDD. Accordingly, in a transistor-based implementation such a level down-shifter needs to be 2VDD, 3VDD or 4VDD tolerant. More generally, a transistor-based level-down shifter down-shifting an input voltage from a higher voltage domain of N×VDD/(N+1)×VDD (e.g., suitable for I/O circuitry), to a lower voltage domain of VSS/VDD (e.g., suitable for logic circuitry) needs to be (N+1)×VDD tolerant. A conventional approach for making a circuit tolerant to higher voltages is to use transistors with thicker gate dielectrics and higher threshold voltages (Vth) than typically needed for the core logic (i.e., standard- or low-Vth transistors). However, including transistors with different gate dielectric thicknesses and threshold voltages may make circuit design and fabrication more complex and costly.

### SUMMARY

It is an object of the present invention to provide a level-down shifter allowing down-shifting of an input voltage from a higher voltage domain of N×VDD/(N+1)×VDD to a lower voltage domain of VSS/VDD without requiring transistors with thicker gate dielectrics and/or higher threshold voltages than typical for core logic. It is further an object to provide a level-down shifter which is (N+1)×VDD tolerant. Further and alternative objectives may be understood from the following.

According to a first aspect of the present invention, there is provided a level shifter for down-shifting a voltage level of a digital input signal LDS_IN, the level shifter comprising:
a supply voltage rail configured to supply a supply voltage and a reference voltage rail configured to supply a reference voltage;
a first branch and a second branch, each comprising:
   an input configured to receive the digital input signal LDS_IN, wherein the input of the first branch is an inverting input and the input of the second branch is a non-inverting input;
   a high-side transistor having a first current terminal coupled to the supply voltage rail, a second current terminal coupled to a first node of the respective branch, and a gate coupled to the input;
   a low-side transistor having a first current terminal coupled to the reference voltage rail, a second current terminal coupled to a second node of the respective branch, and a gate coupled to the second node of the other branch, wherein the second node of the first or second branch is an output of the level shifter; and
   a stack of N transistor pairs (N being an integer equal to or greater than 1) coupled in series between the first and the second nodes, wherein each transistor pair comprises an n-channel metal oxide semiconductor field-effect transistor, nMOSFET (which hereinafter may be abbreviated nFET), and a p-channel metal oxide semiconductor field-effect transistor, pMOSFET (which hereinafter may be abbreviated pFET), the nMOSFET being subsequent to the pMOSFET as seen from the first node to the second node,
   wherein gates of each respective transistor pair of the stack are configured to be biased by a respective bias voltage of a level intermediate the main supply voltage and the reference voltage.

According to the first aspect, there is thus provided a transistor-based level-down shifter wherein the provision of two parallel branches comprising a respective stack of N complementary transistor pairs (CMOS pairs) biased with a respective voltage intermediate the supply and reference voltages enables the voltage level of the input signal to be "stepped down", with the voltage drop distributed over the CMOS pairs of the stack. The biasing of each CMOS pair with a bias voltage intermediate the supply and reference voltages provided by the voltage rails enables the voltage seen by each CMOS pair to be limited to a safe level, i.e., below the breakdown voltage. This reduces the need to use transistors with thicker gate dielectrics and/or higher threshold voltages than typical core logic. The first aspect hence provides a level-down shifter of scalable design, wherein the amount of down-shifting to be provided may be tailored via the number of CMOS pairs in the stack.

Furthermore, given an input signal LDS_IN oscillating between a high and a low logic level, the symmetric design with two parallel and complementary branches enables the output (LDS_OUT) of the level shifter to switch from low-to-high and high-to-low, respectively, at substantially the mid-point (50%) between the high and low logic levels of the input LDS _IN. The output LD_OUT may hence be provided with a same duty cycle as the input LDS_IN.

By first/second "current terminal" of a transistor is here meant a first/second source/drain terminal of the transistor. A current terminal of a transistor may hence be either a source terminal or a drain terminal depending on whether current enters or exits the transistor via the terminal.

By "supply voltage rail" and "reference voltage rail" is here meant respective rails or nodes configured to provide a main supply voltage and a reference voltage (e.g. VSS which may be either a ground level voltage or a negative voltage), respectively, to the level shifter. A voltage rail may be realized as a voltage source (e.g., supplying a supply voltage or a negative reference voltage) or a grounded node (e.g., supplying a ground level voltage).

By "a gate configured to be biased by a bias voltage " is here meant that the gate is connected to a voltage source supplying a respective DC bias voltage.

By an element (e.g., a transistor, a terminal, or a node) being "coupled" to another element (e.g., another transistor, terminal, or node) is here meant a resistive (i.e. galvanic) connection between the elements, unless stated otherwise. The coupling may typically be "direct" in the sense that there are no other intervening circuit components between the elements (e.g. other than a conducting trace or wiring between the elements).

The high-side transistors may be either pMOSFETs or nMOSFETs. In some embodiments, the high-side transistors are pMOSFETs, and the low-side transistors are nMOSFETs. This may contribute to an efficient switching and facilitate implementation of the high- and low-side switching circuitry.

In some embodiments:
the number of transistor pairs of the respective stacks is N≥1;
the supply voltage corresponds to (N+1)×VDD + VSS, and
the bias voltage of a k-th transistor pair (i.e., CMOS pair) of the stack of each branch is lower than the supply voltage and/or the bias voltage of a (k+1)-th transistor pair, where 1 ≤ k ≤ N and wherein the k-th transistor pair is the k-th transistor pair of the respective stack, counted from the second node to the first node.

The term "VDD" is herein used to denote a (positive) unit supply voltage.

The term "VSS" is meanwhile used to denote the reference voltage, which typically may correspond to a ground level (GND, i.e., 0 V) of the level shifter. However, the reference voltage VSS may also be a negative supply voltage, e.g., corresponding to one or more multiples of -VDD. Accordingly, denoting the supply voltage V_{powerrail} it follows that V_{powerrail} - VSS = (N+1)×VDD. However, in many applications (e.g., when using the level shifter to produce an input voltage for core logic), VSS will be 0 V wherein the supply voltage will correspond to (N+1)×VDD.

The bias voltage of the CMOS pairs may hence be gradually stepped-down by each transistor pair along the active branch (i.e. for which the high-side transistor is on), as seen from the high-side transistors to the low-side transistors. Consequently, the level shifter may be configured to down-shift an input voltage LDS_IN with a voltage swing between a high logic level V_{input,high} corresponding to (N+1)×VDD + VSS and a low logic level V_{input,low} corresponding to N×VDD to a voltage swing between a high logic level V_{out,high} corresponding to 1×VDD + VSS and a low logic level V_{out,low} corresponding to VSS. That is, the level shifter may be configured to receive a digital input signal LDS_IN oscillating between a high logic level V_{input,high} corresponding to (N+1)×VDD + VSS and a low logic level V_{input,low} corresponding to N×VDD + VSS and to output a digital output signal LDS_OUT oscillating between a high logic level V_{out,high} corresponding to 1×VDD + VSS and a low logic level V_{out,low} corresponding to VSS.

The bias voltage of the k-th transistor pair of the stack of each branch may in particular correspond to k×VDD + VSS (or simply k×VDD in case VSS = 0 V). The voltage drop may hence be distributed substantially uniformly across the respective CMOS pairs of each branch.

By a voltage (such as the bias voltage of a k-th transistor pair) "corresponding to" another voltage (such as k×VDD) is hereby meant that the voltage substantially matches or is substantially equal to k×VDD. That is, "corresponding" voltages means that the voltages need not necessarily be exactly equal to each other, but may differ to each other to some degree. Such differences may for instance at least in part be attributed to Process-Voltage-Temperature (PVT) variations. For instance, "corresponding" voltages may differ from each other by at most 10%, at most 5% or at most 2%. Voltages with a difference within these ranges may be considered as "corresponding" (i.e., substantially matching or be substantially equal) as these differences will be sufficiently small to not fundamentally alter the function of the level shifter.

In some embodiments, the transistors of the level shifter each have a threshold voltage less than VDD. The transistors may hence be realized as standard- or low-Vth transistors, i.e. the same type of transistors used in typical core logic.

In some embodiments, the pMOSFET and the nMOSFET of each transistor pair each comprise a first current terminal and a second current terminal, wherein the first current terminal of the pMOSFET is coupled to the first current terminal of the nMOSFET, and
wherein the level shifter further comprises, for each transistor pair of the respective stacks, a respective first auxiliary nMOSFET having a gate coupled to the first current terminals of the pMOSFET and the nMOSFET, a first current terminal coupled to a first auxiliary supply voltage, and a second current terminal coupled to the second current terminal of the nMOSFET, wherein the first auxiliary supply voltage corresponds to (substantially matches, is substantial equal to) the bias voltage of the respective transistor pair.

The voltage at the internal node forming the interconnection between the first current terminals of the pFET and nFET of each CMOS pair may hence be supplied as a gate voltage to the gate of an auxiliary nFET, and thus be used to switch on the auxiliary nFET to allow faster charging/discharging of the second current terminal of the nFET of the CMOS pair. In particular, the charging/discharging of the second current terminal may be faster when the voltage at the internal node of the CMOS pair is such that the nFET or pFET of either of the CMOS pairs enters the sub-threshold region.

In some embodiments, the high-side transistors are pMOSFETs, and wherein the pMOSFET and the nMOSFET of each transistor pair each comprise a first current terminal and a second current terminal, wherein the first current terminal of the pMOSFET is coupled to the first current terminal of the nMOSFET, and the level shifter further comprises, for each transistor pair of the respective stacks, a respective second auxiliary nMOSFET having a gate coupled to the second current terminal of the pMOSFET of the respective transistor pair, a first current terminal coupled to a second auxiliary supply voltage, and a second current terminal coupled to the second current terminal of the pMOSFET of the corresponding transistor pair of the other stack, wherein the second auxiliary supply voltage corresponds to (substantially matches, is substantial equal to) the bias voltage of the respective transistor pair.

The voltage at the second current terminal of the pFET of each respective CMOS pair may hence be supplied as a gate voltage to the gate of an auxiliary nFET associated with the CMOS pair of the respective branch. As the second current terminal of the pFET further is coupled to the second current terminal of the pMOSFET of the corresponding transistor pair of the other stack, these auxiliary nFETs of the respective branches may hence be switched on or off, alternatingly, to allow faster charging/discharging of the second current terminal of the pFET of the corresponding CMOS pairs. In particular, the charging/discharging of the second current terminal may be faster when the voltage at the internal node of the CMOS pair is such that the nFET or pFET of either of the CMOS pairs enters the sub-threshold region.

By "corresponding" transistors or "corresponding" CMOS pairs of the transistor stacks of the first and second branches is here meant transistors or CMOS pairs biased by a same bias voltage, or equivalently, the k-th CMOS pair of the respective branches. In other words, CMOS pair k of the first branch / stack corresponds to the CMOS pair k of the second branch / stack.

According to a second aspect there is provided a circuit comprising:
an input signal generator configured to output a digital input signal LDS _IN; and
a level shifter according to the first aspect or any embodiments or variations thereof, the level shifter being configured to receive the digital input signal LDS_IN.

According to a third aspect there is provided a method for down-shifting a voltage level of a digital input signal LDS_IN using a level shifter according to the first aspect or any embodiments or variations thereof, the method comprising:
receiving the digital input signal LDS_IN by the input of the respective branches of the level shifter; and
providing at the output of the level shifter, a digital output signal LDS_OUT.

According to the second and third aspects, the level shifter may thus receive the digital input signal LDS_IN from the input signal generator and provide a down-shifted digital output signal.

The second and third aspect generally presents the same or equivalent effects as the first aspect. Any examples, variations, or functions described in relation to the first aspect, may have corresponding features in the second and third aspects, or vice versa. a system or a computer program product.

The digital input signal LDS_IN received by the level shifter may oscillate between a high logic level V_{input,high} corresponding to (N+1)×VDD + VSS and a low logic level V_{input,low} corresponding to N×VDD + VSS. The digital output signal LDS_OUT provided by the level shifter may oscillate between a high logic level V_{out,high} corresponding to 1×VDD + VSS and a low logic level V_{out,low} corresponding to VSS.

The input signal generator may be configured to generate the digital input signal LDS_IN responsive to an I/O input signal oscillating between a high I/O level corresponding to (2N+1)×VDD + VSS and a low logic level V_{input,low} corresponding to VSS.

Correspondingly, the method of the third aspect may further comprise receiving, by an input signal generator, an I/O input signal oscillating between a high I/O level corresponding to (2N+1)×VDD + VSS and a low logic level V_{input,low} corresponding to VSS, and generating, by an input signal generator, the digital input signal LDS_IN responsive to the I/O input signal

The digital input signal LDS_IN may be output by a Schmitt trigger circuit (e.g., comprised in the input signal generator), the Schmitt trigger circuit being configured to output the digital input signal LDS_IN responsive to an initial digital input signal oscillating between the high and the low logic levels V_{input,high} and V_{input,low}.

The provision of a Schmitt trigger prior to the level shifter may suppress noise which may be present in the initial digital input signal, and hence enable a lower noise output from the level shifter.

### BRIEF DESCRIPTION OF THE DRAWINGS

This and other aspects of the present invention will now be described in more detail, with reference to the appended drawings showing embodiments of the present invention.
Fig. 1 shows a circuit diagram of a level shifter according to an implementation.
Fig. 2 shows a circuit diagram of a level shifter according to a further implementation.
Fig. 3 shows a circuit diagram of a level shifter according to yet a further implementation.
Fig. 4 shows a circuit diagram of a level shifter according to yet a further implementation.
Fig. 5 show results of a simulation of an output voltage of a level shifter of a design according to Fig. 1.
Fig. 6 show results of a simulation of an output voltage of a level shifter of a design according to Fig. 3.
Fig. 7 shows a circuit diagram of a circuit system comprising a level shifter, according to an implementation.

### DETAILED DESCRIPTION

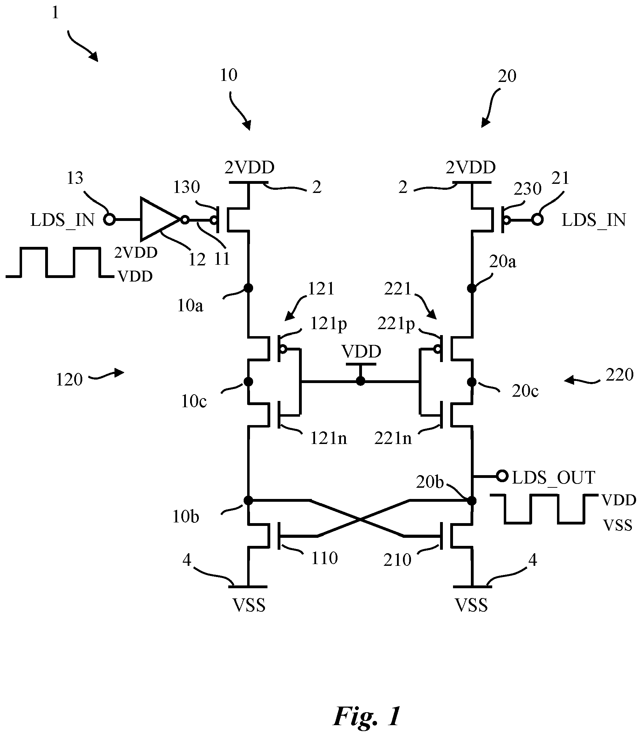

Fig. 1 shows a circuit diagram of a level shifter 1 according to an implementation. As will be explained in detail in the following, the level shifter 1 is of a design suitable for down-shifting a voltage level of an input signal, herein denoted LDS_IN. LDS_IN may as shown in Fig. 1 in particular be a digital input signal oscillating between a high logic level V_{input,high} corresponding to 2×VDD + VSS and a low logic level V_{input,low} corresponding to VDD + VSS. As further shown, the level shifter 1 may in response to LDS_IN provide a digital output signal LDS_OUT oscillating between a high logic level V_{out,high} corresponding to 1×VDD + VSS and a low logic level V_{out,low} corresponding to VSS. VDD is herein denoted a "unit supply voltage" wherein 2×VDD + VSS corresponds to a supply voltage supplied by a supply voltage rail 2 of the level shifter 1. VSS corresponds to a reference voltage supplied by a reference voltage rail 4 of the level shifter 1. In the following, it will be assumed that the reference voltage VSS corresponds to GND (~0 V). Hence, the term VSS will in the following be omitted when discussing input voltages, output voltages, and various node voltages of the level shifter. The unit supply voltage VDD may as an illustrative and non-limiting example be 1.8 V, wherein the level shifter 1 accordingly may down-shift an input voltage LDS_IN of 3.6V/1.8V to an output voltage LDS_OUT of 1.8V/0V. However, as may be appreciated by the skilled person the magnitude of VDD may differ depending on the particular technology node of the transistors. For instance, in the 22-28 nm FinFET node VDD may be about 0.9 V, and in the 14-12 nm node FinFET VDD may be about 0.8 V. In sub-3 nm gate-all-around (GAA) FET technology node VDD may be even lower, e.g., about 0.7 V or 0.65 V. The level shifter of the present disclosure may in particular be useful in circuits based on sub-3 nm GAA-FETs, due to the absence of thick oxide transistors in this node.The level shifter 1 comprises as shown a first and a second (circuit) branch 10, 20. The first and second branches 10, 20 are coupled in parallel between the supply voltage rail 2 and the reference voltage rail 4. The supply voltage rail 2 and the reference voltage rail 4 may also be denoted supply node 2 and reference node 4, respectively.

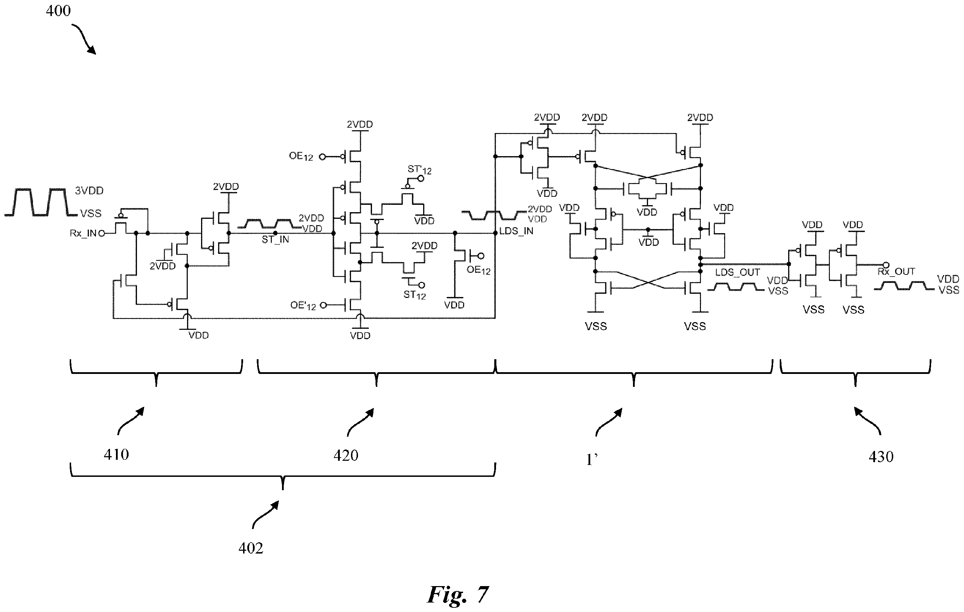

Each of the branches 10, 20 comprises an input or input node 13, 21 configured to receive the digital input signal LDS_IN. As will further described herein, LDS_IN may be received from an input signal generator comprised in circuitry preceding the level shifter 1 (e.g., input signal generator 420 of circuit 400 in Fig. 7).

The input 11 of the first branch 11 is configured as an inverting input. That is, the first branch 10 comprises an inverter 12 preceding the input node 11 (e.g., comprising a CMOS pair) and configured to receive LDS_IN and output an inverted representation of LDS_IN (hereinafter denoted ~DS_IN). The input 21 of the second branch 20 is configured as a non-inverting input.

Each branch 10, 20 comprises a transistor-based circuit comprising nFETs and pFETs, more specifically enhancement-mode nFETs and pFTETs.

Each branch 10, 20 comprises a high-side transistor 130, 230 (interchangeably pull-up transistor) having a first current terminal (e.g., a source) coupled to the main supply voltage rail 2, a second current terminal (e.g., a drain) coupled to a first node 10a, 20a of the respective branch 10, 20, and a gate coupled to the input 11, 21. Accordingly, ~LDS_IN is provided as a gate signal to the high-side transistor 130 of the first branch 10 and LDS_IN is provided as a gate signal to the high-side transistor 230 of the second branch 10. The high-side transistors 130, 230 may typically be implemented as pFETs.

Each branch 10, 20 further comprises a low-side transistor 110, 210 (interchangeably pull-up transistor) having a first current terminal (e.g. a source) coupled to the reference voltage rail (4), a second current terminal (e.g. a drain) coupled to a second node 10b, 20b of the respective branch 10, 20, and a gate coupled to the second node 20b, 10b of the other branch 20, 10. The low-side transistors 110, 210 may typically be implemented as nFETs.

In the illustrated implementation, the second node 20b of the second branch 20 defines an output or output node of the level shifter 1. However, it is also possible to configure the second node 10b of the first branch 10 as the output of the level shifter 1. As will become apparent from the following, the second node 20b will provide an output signal LDS_OUT out-of-phase with LDS _IN while the second node 10b will provide an output signal LDS_OUT in-phase with LDS_IN.

Each branch 10, 20 further comprises a stack 120, 220 of transistor pairs 121, 221 coupled in series between the first node 10a-b and the second node 20a-b, respectively. Each transistor pair 121, 221 is formed by a complementary pair of transistors (i.e., a CMOS pair), an nFET 121n, 221n and a pFET 121p, 221p. The pFET 121p, 221p of the respective CMOS pairs 121, 221 is as shown provided subsequent to, i.e. above, its associated nFET 121n, 221n in the stack 120, 220, as seen from the second node 10b, 20b to the first node 10a, 20a. The pFETs 121p, 221p are hence provided closer to the respective high-side transistors 130, 230 than the nFETs 121n, 221n.

The gates of each CMOS transistor pair 121, 221 are configured to be biased by a respective DC-level bias voltage corresponding to the unit supply voltage VDD, which is a voltage intermediate the main supply voltage 2×VDD and the reference voltage VSS, more specifically corresponding to half the main supply voltage and half the high logic level V_{input,high} of LDS_IN. The maximum voltage drop seen by any one of the transistors of the level shifter 1 may hence be approximately VDD, meaning that the level shifter 1 may be 2×VDD tolerant even if the transistors are realized as standard- or low-Vth transistors.

The level shifter 1 will now be described during operation, receiving the oscillating digital voltage input signal LDS_IN. The parameter Vth will in the following used to denote a respective threshold voltage of the transistors of the level shifter 1. While a same label Vth will be used with reference to each of the transistors, it to be understood that the threshold voltage may vary among the transistors (e.g. due to PVT variations and/or the level shifter 1 comprising a mixture of standard- and low-Vth FETs). By way of example, the threshold voltages of the transistors of the level shifter 1 may be in a range of about 0.1 to 1 V, such as in a range of about 0.15-0.6 V.

When LDS_IN is low (i.e. LDS_IN = V_{input,low} = VDD), the (inverting) input 11 is high (-LDS_IN = V_{input,high} = 2×VDD) and the (non-inverting) input 21 is low (LDS_IN = V_{input,low} = VDD).

Accordingly, in the second branch 20, the high-side transistor 230 switches on wherein the node 20a is charged to 2×VDD by the supply voltage rail 2. In turn, the pFET 221p switches on wherein the node 20c (i.e. the internal node of the CMOS pair 221) is charged to 2×VDD. In turn, the nFET 221n switches on wherein the node 20b (which in the illustrated implementation defines the output of the level shifter 1) is charged to VDD. As the voltage at node 20b reaches VDD-Vth (where Vth is the threshold voltage of the nFET 221n) the nFET 221n enters the subthreshold region (Vgs<Vth) wherein the node 20b will be charged at a rate corresponding to the subthreshold leakage of the nFET 221n.

In the first branch 10, the voltage at the node 20b defines the gate voltage for the low-side transistor 110 wherein the charging of the node 20b towards VDD in turn will switch on the low-side transistor 110 wherein the node 10b of the first branch 10 will be discharged to VSS. In turn, the nFET 121n of the CMOS pair 121 switches on wherein the node 10c (i.e. the internal node of the CMOS pair 121) will be discharged to VSS. In turn, the pFET 121p switches on wherein the node 10a is discharged to VDD. As the voltage at node 10b reaches VDD+Vth (where Vth is the threshold voltage of the pFET 121p) the pFET 121p enters the subthreshold region (Vsg<Vth) wherein the node 10a will be discharged at a rate corresponding to the subthreshold leakage of the pFET 121p. In turn, the high-side transistor 130 switches off.

When LDS_IN is high (i.e. LDS_IN = V_{input,high} = 2×VDD), the (inverting) input 11 is low (-LDS_IN = V_{input,low} = VDD) and the (non-inverting) input 21 is high (LDS_IN = V_{input,high} = 2×VDD).

Accordingly, in the first branch 10, the high-side transistor 130 switches on wherein the node 10a is charged to 2×VDD by the supply voltage rail 2. In turn, the pFET 121p switches on wherein the node 10c (i.e. the internal node of the CMOS pair 121) is charged to 2×VDD. In turn, the nFET 221n switches on wherein the node 10b is charged to 2×VDD. As the voltage at node 10b reaches VDD-Vth (where Vth is the threshold voltage of the nFET 121n) the nFET 121n enters the subthreshold region (Vgs<Vth) wherein the node 10b will be charged at a rate corresponding to the subthreshold leakage of the nFET 121n.

In the second branch 20, the voltage at the node 10b defines the gate voltage for the low-side transistor 210 wherein the charging of the node 10b to VDD in turn will switch on the low-side transistor 210 wherein the node 20b of the second branch 20 will be discharged to VSS. In turn, the nFET 221n of the CMOS pair 221 switches on wherein the node 20c (i.e. the internal node of the CMOS pair 121) will be discharged to VSS. In turn, the pFET 221p switches on wherein the node 20a is discharged to VDD. As the voltage at node 20b reaches VDD+Vth (where Vth is the threshold voltage of the pFET 221p) the pFET 221p enters the subthreshold region (Vsg<Vth) wherein the node 20a will be discharged at a rate corresponding to the subthreshold leakage of the pFET 221p.

Accordingly, the level shifter 1 may during operation, responsive to an input signal LDS_IN with a voltage swing of approximately VDD/2×VDD, provide an output signal LDS_OUT with a voltage swing of approximately VSS/VDD.

Furthermore, due to the symmetric design of the level shifter 1, when the input LDS_IN falls from 2×VDD to 1.5×VDD the output LDS_OUT may rise correspondingly from VSS to 0.5×VDD, and vice versa. The duty cycle of LDS_OUT may hence correspond to the duty cycle of the input LDS_IN. For example, provided the duty cycle of the input signal LDS_IN is 50%, the level shifter may transfer the input signal LDS_IN to a down-shifted output voltage with a preserved duty cycle of 50%.

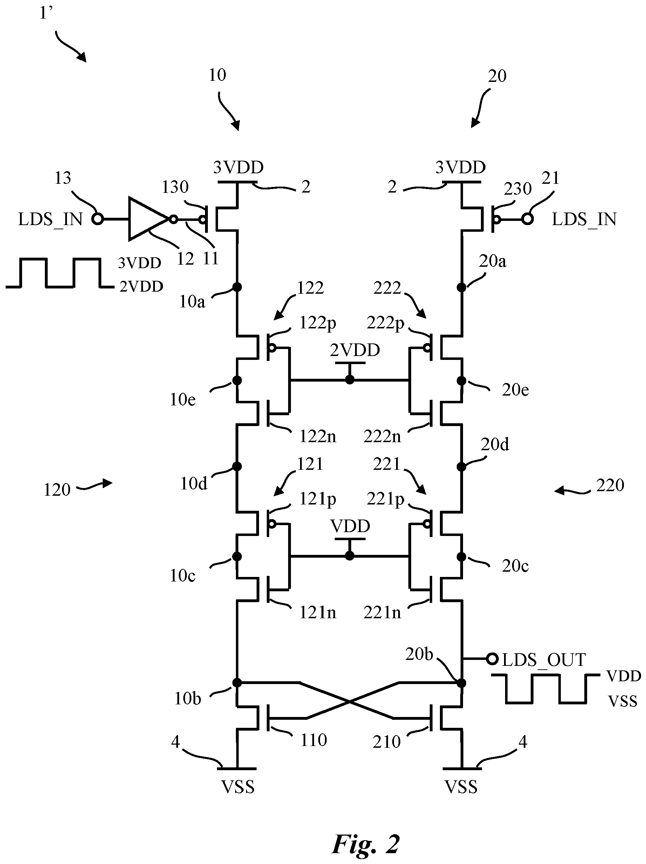

Fig. 2 shows a circuit diagram of a level shifter 1' according to a further implementation. The level shifter 1' differs from the level shifter 1 of Fig. 1 in that it is suitable for down-shifting a voltage level of a digital input signal LDS_IN oscillating between a high logic level V_{input,high} corresponding to 3×VDD and a low logic level V_{input,low} corresponding to 2×VDD. To handle the higher level of V_{input,high} the supply voltage rail 2 is configured to supply a supply voltage corresponding to 3×VDD. Furthermore, the number of CMOS pairs (N) in the respective transistor stacks 120, 220 has been increased to two (N=2). Accordingly, the transistor stack 120 of the first branch 10 comprises a first CMOS pair 121 and a second CMOS pair 122. Correspondingly, the transistor stack 220 of the second branch 20 comprises a first CMOS pair 221 and a second CMOS pair 222. Letting k denote the position (or level) of a CMOS pair in each stack 120, 220, counted from the second node 10b, 20b to the first node 10a, 10b, k=1 for the first CMOS pairs 121 and 221 and k=2 for the second CMOS pairs 122, 222. Hence, more generally, the k-th CMOS pair of a stack 120 or 220 refers to the CMOS pair at position k of the stack.

The CMOS pairs 121, 122 and 221, 222 are identical to each other however they are differently biased in that a bias voltage of the first CMOS pairs 121, 221 is lower than a bias voltage of the second CMOS pairs 122, 222 which is lower than the supply voltage of the supply voltage rail 2. According to the illustrated implementation, the bias voltage supplied to the gates of the first CMOS pairs 121, 221 (k= 1) corresponds to 1×VDD and the bias voltage supplied to the gates of the second CMOS pairs 122, 222 (k=2) corresponds to 2×VDD. This allows the total voltage drop of 3×VDD across the level shifter 1' to be divided substantially uniformly across the CMOS pairs 121, 221, 122, 222.

The operation of the level shifter 1' will proceed in an analogous manner to the level shifter 1 with the addition that the voltage will be gradually stepped down (or up along the parallel branch) at each CMOS pair 121, 122, 221, 222 of the respective branches 10, 20. That is, when LDS_IN is low:
- the high-side transistor 230 switches on wherein the nodes 20a and 20e will be charged to 3×VDD, the nodes 20d and 20c will be charged to 2×VDD and the node 20b will be charged to 1×VDD; and
- the nodes 10b and 10c will be discharged to VSS, the nodes 10d and 10e will be discharged to VDD and the node 10a will be discharged to 2×VDD.

When LDS_IN is high:
- the high-side transistor 130 switches on wherein the nodes 10a and 10e will be charged to 3×VDD, the nodes 10d and 10c will be charged to 2×VDD and the node 10b will be charged to 1×VDD; and
- the nodes 20b and 20c will be discharged to VSS, the nodes 20d and 20e will be discharged to VDD and the node 20a will be discharged to 2×VDD.

In the above discussion of the operation of the level shifter 1 and 1', it has been tacitly assumed that the subthreshold leakages of the nFETs and pFETS of the CMOS pairs of the transistor stacks 120, 220 are sufficiently large relative the duration of the high and low logic levels V_{input,high} and V_{input,low} of the digital input signal LDS_IN, for the respective nodes to "fully" charged or discharged to VSS, VDD or multiples of VDD, as the case may be, despite the limited (dis-)charge rate provided by an nFET or pFET in the subthreshold region. This assumption is for instance applicable to FETs realized in planar technology and less aggressive scaled nodes of FinFET, as they tend to exhibit relatively high sub-threshold leakage. However, in more recent technology nodes (e.g., sub-3 nm GAA FET technology), the considerably smaller sub-threshold leakage may limit the performance of the level shifter. In particular, a small sub-threshold leakage may distort the signals at the internal nodes of the level shifter such that the output LDS_OUT is delayed relative the input LDS_IN.

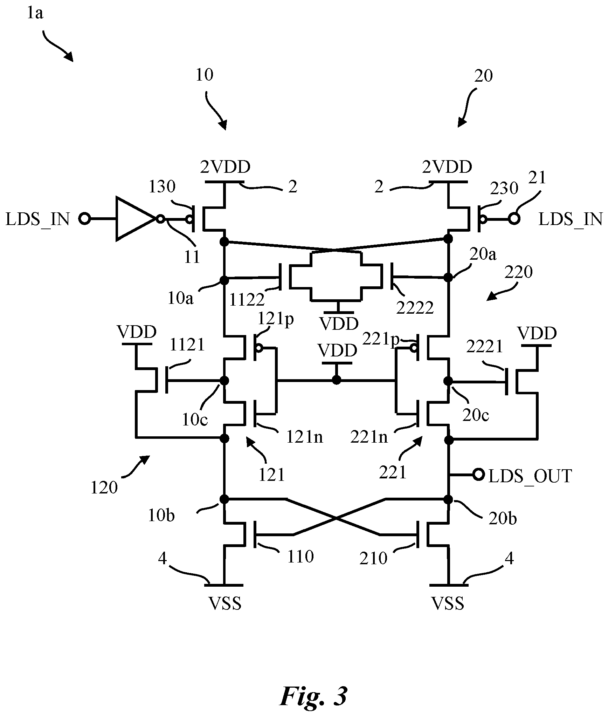

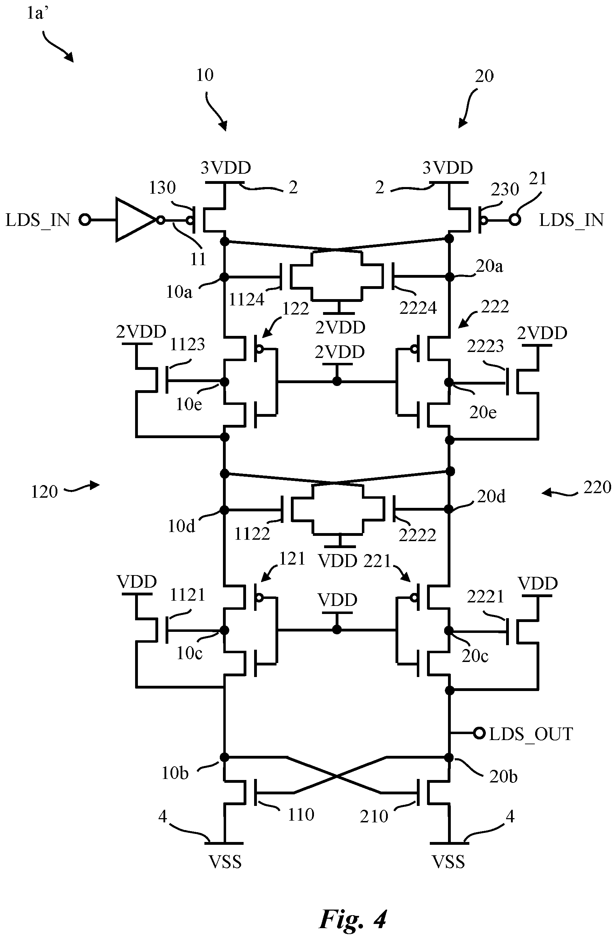

Implementations of a level shifter enabling faster charging/discharging in the subthreshold region will now be described with reference to Fig. 3 and 4.

Fig. 3 shows a level shifter 1a corresponding to the level shifter 1 of Fig. 1 however differing by comprising a number of supplemental transistors for improved performance. More specifically, the first branch 10 and the second branch 20 have each been supplemented with a respective first auxiliary nFET 1121, 2221. The auxiliary nFET 1121 has a gate coupled to first current terminals of the pFET and nFET 121p, 121n at the internal node 10c of the CMOS pair 121. The auxiliary nFET 1121 further has a first current terminal (e.g., a drain) coupled to a first auxiliary supply voltage corresponding to VDD, and a second current terminal (e.g., a source) coupled to a second (outer) current terminal of the nFET 121n.

The auxiliary nFET 2221 of the second branch 20 has a corresponding configuration and accordingly has a gate coupled to first current terminals of the pFET and nFET 221p, 221n at the internal node 20c of the CMOS pair 221. The auxiliary nFET 2221 further has a first current terminal (e.g., a drain) coupled to a first auxiliary supply voltage corresponding to VDD, and a second current terminal (e.g., a source) coupled to a second (outer) current terminal of the nFET 221n.

The first current terminals of the auxiliary nFETs 1121, 2221 are thus each configured to be supplied a first auxiliary supply voltage corresponding to VDD. The first auxiliary supply voltage may as indicated in Fig. 3 be supplied by an auxiliary power rail wherein the first current terminals of the auxiliary nFETs 1121, 2221 may be coupled thereto.

Notably, the first auxiliary supply voltage corresponds to the bias voltage of the CMOS pairs 121, 221. Thereby, during operation, when LDS_IN is low, as the internal node 20c is charged to 2×VDD, the auxiliary nFET 2221 will be switched on and thus contribute to a faster charging of the node 20b to VDD (which in Fig. 3 is configured as the output of the level shifter 1a). Correspondingly, when LDS_IN is high, as the internal node 10c is charged to 2×VDD, the auxiliary nFET 1121 will be switched on and thus contribute to a faster charging of the node 10b to VDD.

The first branch 10 and the second branch 20 have each further been supplemented with a respective second auxiliary nFET 1121, 2221. The auxiliary nFET 1121 has a gate coupled to the second (outer) current terminal of the pFET 121p, a first current terminal (e.g., a drain) coupled to a second auxiliary supply voltage corresponding to VDD, and a second current terminal (e.g., a source) coupled to the second (outer) current terminal of the pFET 221p of the corresponding transistor pair 221 of the other stack 220.

The auxiliary nFET 2222 of the second branch 20 has a corresponding configuration and accordingly has a gate coupled to the second (outer) current terminal of the pFET 221p, a first current terminal (e.g., a drain) coupled to a second auxiliary supply voltage corresponding to VDD, and a second current terminal (e.g., a source) coupled to the second (outer) current terminal of the pFET 121p of the corresponding transistor pair 121 of the other stack 120.

The first current terminals of the auxiliary nFETs 1122, 2222 are thus each configured to be supplied a second auxiliary supply voltage corresponding to VDD. The second auxiliary supply voltage may as indicated in Fig. 3 be supplied by an auxiliary power rail wherein the first current terminals of the auxiliary nFETs 1122, 2222 may be coupled thereto.

Notably, the second auxiliary supply voltage corresponds to the bias voltage of the CMOS pairs 121, 221. Thereby, during operation, when LDS_IN is low, as the internal node 20a is charged to 2×VDD, the auxiliary nFET 2222 will be switched on and thus contribute to a faster discharging of the node 10a to VDD. Correspondingly, when LDS_IN is high, as the internal node 10a is charged to 2×VDD, the auxiliary nFET 1122 will be switched on and thus contribute to a faster discharging of the node 20a to VDD.

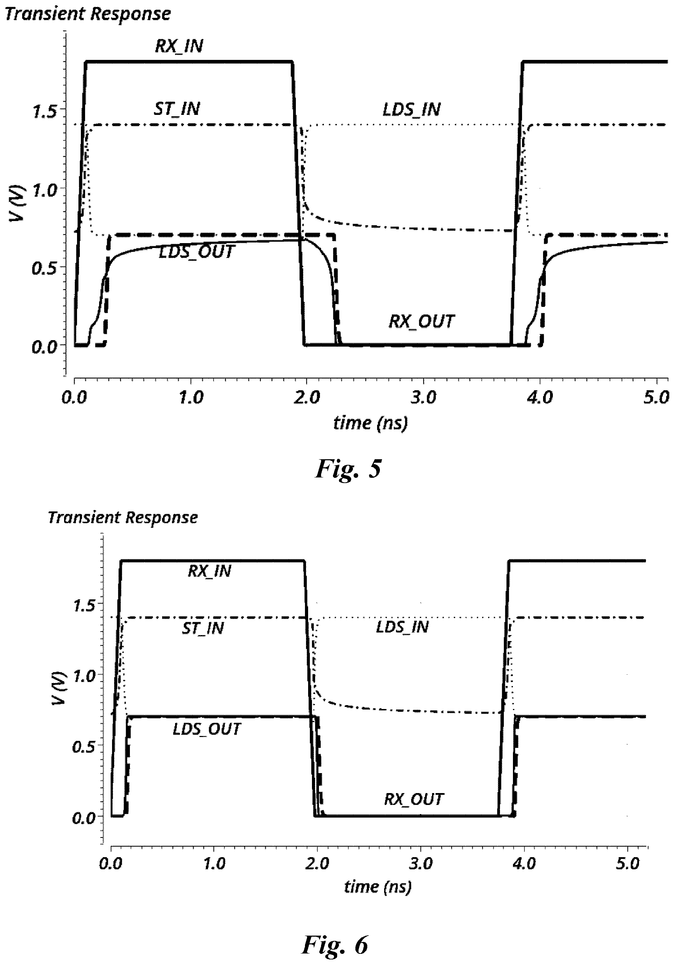

Fig. 5 show results of a simulation of the output voltage LDS_OUT (thin solid line) responsive to a digital input signal LDS_IN (dotted line) with a voltage swing of VDD=0.7 V to 2×VDD=1.4 V, for a level shifter with the design of the level shifter 1 of Fig. 1 (without the supplementary transistors). Fig. 6 shows the corresponding results for a level shifter with the design of the level shifter 1' of Fig. 3 (with the supplementary transistors). As may be seen, the level shifter 1' provides faster rise- and fall-times of the output voltage LDS_OUT, wherein LDS_OUT better tracks the input voltage LDS_IN with reduced delay. This improvement may be attributed to the first auxiliary nFETs 1121, 2221 contributing to a shorter transient at nodes 10b and 20b, and to the second auxiliary nFETs 1122, 2222 contributing to a shorter transient at nodes 10a and 20a.

While the level shifter 1' includes both first and second auxiliary nFETs, it is possible to include them separately from one another, e.g., to enable faster charging/discharging at either nodes 10b, 20b or at nodes 10a, 20a.

Supplementary transistors may in an analogous manner be incorporated in the level shifter 1'. Fig. 4 shows such a level shifter 1a' wherein each CMOS pair 121, 122, 221, 222 of the level shifter 1a' has been supplemented with a respective first auxiliary transistor (e.g., nFET 1121 at CMOS pair 121, nFET 1123 at CMOS pair 122, nFET 2221 at CMOS pair 221, nFET 2223 at CMOS pair 222) and a respective second auxiliary transistor (e.g. having a gate coupled to the internal node of the associated CMOS pair, a first current terminal coupled to a first auxiliary supply voltage, and a second current terminal coupled to the second (outer) current terminal of nFET of the associated CMOS pair. The respective auxiliary supply voltages for the first and second auxiliary transistors correspond to the bias voltage of the associated CMOS pair (e.g., k×VDD for the first and second auxiliary transistors associated with CMOS pair k). The faster charging/discharging may hence be provided at each level k of the transistor stacks 120, 220. Without the supplementary transistors, the distortion and delay discussed above at each level k of the transistor stacks will add up and contribute to an increased delay of the output LDS _OUT.

While in the above, 2×VDD and 3×VDD tolerant level shifters have been shown. The design principle may be extended to (N+1)×VDD, where N>2, by increasing the number of CMOS pairs in the transistor stacks 120, 220 accordingly. As may be understood from the above, a biasing voltage of each CMOS pair 1≤k≤N of each stack 120, 220 (and if present the first/second auxiliary transistors) may correspond to k×VDD. The unit supply voltage VDD hence corresponds to the amount by which the bias voltage of the CMOS pair at each level k of the stacks 120, 220 increases relative the reference voltage (for k=1) and relative the bias voltage for the CMOS pair at the preceding level k-1 (for k>1). Increasing the bias voltage in discrete steps of substantially uniform size (VDD) contributes to a uniform distribution of the total voltage drop across the CMOS pairs of a level shifter.

Fig. 7 shows a circuit or circuit system 400 comprising, in addition to a level shifter 1', an input signal generator 402 configured to output a digital input signal LDS_IN to the level shifter 1'. The circuit 400 may for instance form part of an I/O input buffer stage of an integrated circuit. The circuit 400 may be used in various mixed-voltage applications comprising an I/O voltage domain input signal and a core voltage domain output signal, for instance in interfaces such as communication buses (e.g. Serial Peripheral Interface (SPI)) and memory interfaces (e.g., SD card readers). Further applications include digital I/O, Power Management ICs, and mixed-voltage ADCs and DACs.

In the illustrated example, the input signal generator 402 comprises a Schmitt trigger circuit 420. The Schmitt trigger circuit 420 is configured to output the digital input signal LDS_IN responsive to an initial digital input signal ST_IN oscillating with a same voltage swing as LDS_IN, which in the illustrated example corresponds to VDD/2×VDD. The complementary input nodes OE12, OE' 12 are respective enabling inputs. When OE12 is high (e.g., 2×VDD) and OE' 12 is low (e.g., VDD) the level shifter 1' will not be used. When OE12 is low (e.g., VDD) and OE' 12 is high (e.g., 2×VDD) the level shifter 1' will be used. The complementary input nodes ST' 12 and ST' 12 are respective enabling inputs for the Schmitt trigger. It is here noted that other circuit implementations of a Schmitt trigger than the illustrated example are possible.

The initial digital input signal ST_IN may in turn be received by the Schmitt trigger 420 from a bias generator circuit 410 of the input signal generator 402. The bias generator circuit 410 may as indicated generate the initial digital input signal ST_IN with voltage swing VDD/2×VDD based on an I/O input signal RX_IN with voltage swing VSS/3×VDD. The I/O input signal may e.g. be received from a power supply via an I/O input pad. It is here noted that other circuit implementations of a bias generator circuit than the illustrated example are possible. While the provision of a Schmitt trigger in the input signal generator 402 prior to the level shifter may suppress noise which may be present in the initial digital input signal, and hence enable a lower noise output from the level shifter 1', it is also possible to omit a Schmitt trigger wherein level shifter 1' may receive the output signal directly from the bias generator circuit 410 as the digital input signal LDS_IN.

The level shifter 1' may be preceded by a buffer stage 430 comprising one or more output buffers, e.g., implemented by one or more CMOS inverters.

With reference again to Fig. 5 and Fig. 6, there is further shown voltage waveforms corresponding to the I/O input signal RX_IN (thick solid line) received by the bias generator circuit 410, the initial digital input signal ST_IN (dash-dotted line) received by the Schmitt trigger 420, and the output voltage RX_OUT (dashed line) of the buffer stage 430. As may be seen, the output signal LDS _OUT closely tracks both the I/O input signal RX_IN and the digital input signals ST_IN and LDS_IN in terms of timing and duty cycle, in particular in Fig. 6. M. -D. Ker and S. -L. Chen in "Design of Mixed-Voltage I/O Buffer by Using NMOS-Blocking Technique" (IEEE Journal of Solid-State Circuits, vol. 41, no. 10, pp. 2324-2333, Oct. 2006, doi: 10.1109/JSSC.2006.881546) discloses a conventional NMOS blocking technique wherein two nFETs in series are used to sequentially step down an I/O input voltage from 3VDD/GND to (2VDD-Vth)/ GND to (VDD-Vth)/GND NFETs. While this conventional technique requires a relatively small number of transistors, it does not allow preserving the duty cycle of the I/O input voltage in the down-shifted voltage, nor track the I/O input voltage, as well as the level shifter according to the present disclosure.

While the circuit 400 is shown to comprise the level shifter 1', it is also possible to implement any of the level shifters 1, 1a and 1a' in a corresponding circuit, with appropriate adaption of the respective voltage ranges of the I/O input signal, the initial digital input signal and the digital input signal LDS_IN.

More generally, a circuit may comprise an input signal generator comprising a bias generator circuit (corresponding to bias generator circuit 410) configured to generate a digital input signal oscillating between a high logic level V_{input,high} corresponding to (N+1)×VDD + VSS and a low logic level V_{input,low} corresponding to N×VDD + VSS, responsive to an I/O input signal oscillating between a high I/O level corresponding to (2N+1)×VDD + VSS and a low I/O level corresponding to VSS. The input signal generator may optionally further comprise a Schmitt trigger (corresponding to Schmitt trigger 420) preceding the bias generator circuit. The circuit may further comprise a level shifter configured to receive the digital input signal LDS_IN from the input signal generator (e.g., directly from the bias signal generator or via the Schmitt trigger), wherein the level shifter is implemented in accordance with the present disclosure (e.g., in accordance with the level shifters 1, 1a or 1a') and is configured to down-shift the digital input signal LDS_IN to generate a digital output signal LDS _OUT oscillating between a high logic level V_{out,high} corresponding to 1 ×VDD + VSS and a low logic level V_{out,low} corresponding to VSS. The level shifter may be preceded by a buffer stage (corresponding to a buffer stage 430).

The person skilled in the art realizes that the present invention by no means is limited to the embodiments described above. On the contrary, many modifications and variations are possible within the scope of the appended claims.

## Claims

1. A level shifter (1) for down-shifting a voltage level of a digital input signal LDS_IN, the level shifter (1) comprising:
a supply voltage rail (2) configured to supply a supply voltage and a reference voltage rail (4) configured to supply a reference voltage;
a first branch (10) and a second branch (20), each comprising:
an input (11, 21) configured to receive the digital input signal LDS_IN, wherein the input (11) of the first branch (10) is an inverting input and the input (21) of the second branch (20) is a non-inverting input;
a high-side transistor (130, 230) having a first current terminal coupled to the supply voltage rail (2), a second current terminal coupled to a first node (10a, 20a) of the respective branch (10, 20), and a gate coupled to the input (11, 21);
a low-side transistor (110, 210) having a first current terminal coupled to the reference voltage rail (4), a second current terminal coupled to a second node (10b, 20b) of the respective branch (10, 20), and a gate coupled to the second node (20b, 10b) of the other branch (20, 10), wherein the second node (10b, 20b) of the first or second branch (10, 20) is an output of the level shifter (1); and
a stack (120, 220) of N≥1 transistor pairs (121, 221) coupled in series between the first and the second nodes (10a-b, 20a-b), wherein each transistor pair (121, 221) comprises an n-channel metal oxide semiconductor field-effect transistor, nMOSFET, (121n, 221n) and a p-channel metal oxide semiconductor field-effect transistor, pMOSFET, (121p, 221p), the nMOSFET (121n, 221n) being subsequent to the pMOSFET (121p, 221p) as seen from the first node (10a, 20a) to the second node (10b, 20b),
wherein gates of each respective transistor pair of the stack (120, 210) are configured to be biased by a respective bias voltage of a level intermediate the main supply voltage and the reference voltage.

2. The level shifter (1, 1') according to claim 1, wherein:
the number of transistor pairs (121-122, 221-222) of the respective stacks (120, 220) is N≥1,
the supply voltage corresponds to (N+1)×VDD + VSS, where VDD is a unit supply voltage and VSS is the reference voltage, and
the bias voltage of a k-th transistor pair (121-122, 221-222) of the stack (120, 220) of each branch (10, 20) is lower than the supply voltage and/or the bias voltage of a (k+1)-th transistor pair (121-122, 221-222), where 1 ≤ k ≤ N and wherein the k-th transistor pair is the k-th transistor pair of the respective stack (120, 220), counted from the second node (10b, 20b) to the first node (10a, 20a).

3. The level shifter (1, 1') according to claim 2, wherein the bias voltage of the k-th transistor pair (121-122, 221-222) of the stack (120, 220) of each branch (10, 20) corresponds to k×VDD + VSS.

4. The level shifter (1, 1') according to any one of claims 2-3, wherein the level shifter is configured to receive the digital input signal LDS_IN as a signal oscillating between a high logic level V_{input,high} corresponding to (N+1)×VDD + VSS and a low logic level V_{input,low} corresponding to N×VDD + VSS and to output a digital output signal LDS_OUT oscillating between a high logic level V_{out,high} corresponding to 1×VDD + VSS and a low logic level V_{out,low} corresponding to VSS.

5. The level shifter (1a, 1a') according to any one of the preceding claims,
wherein the pMOSFET (121p, 221p) and the nMOSFET (121n, 221n) of each transistor pair (121, 221) each comprise a first current terminal and a second current terminal, wherein the first current terminal of the pMOSFET (121p, 221p) is coupled to the first current terminal of the nMOSFET (121n, 221n), and
wherein the level shifter (1') further comprises, for each transistor pair (121, 221) of the respective stacks (120, 220), a respective first auxiliary nMOSFET (1121, 2221) having a gate coupled to the first current terminals of the pMOSFET and the nMOSFET (121n, 121p, 221n, 221p), a first current terminal coupled to a first auxiliary supply voltage, and a second current terminal coupled to the second current terminal of the nMOSFET (121n, 221n), wherein the first auxiliary supply voltage corresponds to the bias voltage of the respective transistor pair (121, 221).

6. The level shifter (1a, 1a') according to any one of the preceding claims, wherein the high-side transistors (130, 230) are pMOSFETs,
wherein the pMOSFET (121p, 221p) and the nMOSFET (121n, 221n) of each transistor pair (121, 221) each comprise a first current terminal and a second current terminal, wherein the first current terminal of the pMOSFET (121p, 221p) is coupled to the first current terminal of the nMOSFET (121n, 221n), and
wherein the level shifter (1') further comprises, for each transistor pair (121, 221) of the respective stacks (120, 220), a respective second auxiliary nMOSFET (1122, 2222) having a gate coupled to the second current terminal of the pMOSFET (121p, 221p) of the respective transistor pair (121, 221), a first current terminal coupled to a second auxiliary supply voltage, and a second current terminal coupled to the second current terminal of the pMOSFET (221p, 121p) of the corresponding transistor pair (221, 121) of the other stack (220, 120), wherein the second auxiliary supply voltage corresponds to the bias voltage of the respective transistor pair (121, 221).

7. The level shifter (1, 1') according to any one of the preceding claims, wherein the transistors of the level shifter (1, 1', X) each have a threshold voltage less than VDD.

8. The level shifter (1, 1') according to any one of the preceding claims, wherein the high-side transistors (130, 230) are pMOSFETs, and wherein the low-side transistors (110, 220) are nMOSFETs.

9. A circuit (400) comprising:
an input signal generator (402) configured to output a digital input signal LDS_IN; and
a level shifter (1, 1') according to any one of the preceding claims, configured to receive the digital input signal LDS_IN.

10. The circuit according to claim 11, wherein the digital input signal LDS_IN oscillates between a high logic level V_{input,high} corresponding to (N+1)×VDD + VSS and a low logic level V_{input,low} corresponding to N×VDD + VSS, where VDD is a unit supply voltage and VSS is the reference voltage, and wherein the supply voltage is (N+1)×VDD + VSS.

11. The circuit according to claim 10, wherein the input signal generator is configured to generate the digital input signal LDS_IN responsive to an I/O input signal oscillating between a high I/O level corresponding to (2N+1)×VDD + VSS and a low logic level V_{input,low} corresponding to VSS.

12. The circuit according to any one of claims 10-11, wherein the input signal generator comprises a Schmitt trigger circuit configured to output the digital input signal LDS_IN responsive to an initial digital input signal oscillating between the high and the low logic levels V_{input,high} and V_{input,low}.

13. A method for down-shifting a voltage level of a digital input signal LDS_IN using a level shifter according to any one of claims 1-8, the method comprising:
receiving the digital input signal LDS_IN by the input of the respective branches of the level shifter; and
providing at the output of the level shifter, a digital output signal LDS_OUT.

14. The method of claim 13, wherein the digital input signal LDS_IN oscillates between a high logic level V_{input,high} corresponding to (N+1)×VDD + VSS and a low logic level V_{input,low} corresponding to N×VDD + VSS, and wherein the digital output signal LDS_OUT oscillates between a high logic level V_{out,high} corresponding to 1×VDD + VSS and a low logic level V_{out,low} corresponding to VSS.

15. The method of claim 14, further comprising receiving, by an input signal generator, an I/O input signal oscillating between a high I/O level corresponding to (2N+1)×VDD + VSS and a low logic level V_{input,low} corresponding to VSS, and generating, by an input signal generator, the digital input signal LDS_IN responsive to the I/O input signal.
